# EUROPEAN PATENT SPECIFICATION

(11) **EP 0 725 315 B1**
(45) Date of publication and mention of the grant of the patent: **02.05.2001**
(21) Application number: 96300399.1
(22) Date of filing: 22.01.1996
(51) Int. Cl.: G03F 7/075, G03C 7/12

(54) **Photosensitive resin composition and method for forming pattern using the same**
Fotoempfindliche Harzzusammensetzung und Verfahren zur Herstellung von Feinstrukturen damit
Composition photosensible à base de résine et procédé de fabrication d'images avec cette composition

(30) Priority: 25.01.1995 JP 1010395
(43) Date of publication of application: 07.08.1996
(73) Proprietor: Nippon Paint Co., Ltd., Osaka-shi Osaka-fu (JP)
(72) Inventor: Tsushima, Hiroshi, Takatsuki-shi, Osaka-fu (JP); Mikami, Shigeru, Nishinomiya-shi, Hyogo-ken (JP); Watanabe, Emi, Osaka-shi, Osaka-fu (JP); Imamura, Tsuyoshi, Katano-shi, Osaka-fu (JP); Sumiyoshi, Iwao, Osaka-shi, Osaka-fu (JP)
(74) Representative: Perry, Robert Edward

(56) References cited:
- EP-A- 0 502 662
- EP-A- 0 552 035
- PATENT ABSTRACTS OF JAPAN vol. 011, no. 015 (P-536), 16 January 1987 & JP 61 189533 A (HITACHI LTD), 23 August 1986,
- PATENT ABSTRACTS OF JAPAN vol. 94, no. 010 & JP 06 289528 A (NIPPON PAINT CO LTD), 18 October 1994,
- H. TSUSHIMA ET AL.: "SID INTERNATIONAL SYMPOSIUM, DIGEST OF TECHNICAL PAPERS" 14 June 1994 , SOCIETY FOR INFORMATION DISPLAY , SANTA ANA, CA, USA XP000462754 * page 936 - page 939 *

## Description

### FIELD OF THE INVENTION

The present invention relates to a photosensitive resin composition and a method for forming a pattern using the same.

### BACKGROUND OF THE INVENTION

A color filter has been used for a liquid crystal color display using a liquid crystal as an optical shutter. Heretofore, the present inventors have developed a method for producing a color filter utilizing a photodegradation of an organic polysilane.

For example, Japanese Laid-Open Patent Publication No. 5 (1993)-273410 discloses a method of exposing a polysilane layer to light and dipping it in a coloring sol using a metal alkoxide containing a dye or a pigment. Also Japanese Laid-Open Patent Publication No. 5 (1993)-47782 discloses a method for exposing a polysilane layer formed on a transparent electroconductive substrate to light and electrodepositing a pattern on the irradiated area of a polysilane layer using an electrodeposition solution containing a dye or a pigment.

The above methods using the polysilane layer have a problem that a long-time exposure is required.

### OBJECTS OF THE INVENTION

An object of the present invention is to solve the above problem, thereby providing a method for producing a color filter, which is simple and superior productivity.

This object as well as other objects and advantages of the present invention will become apparent to those skilled in the art from the following description with reference to the accompanying drawings.

### BRIEF EXPLANATION OF THE DRAWINGS

Fig. 1 is a schematic flow sheet illustrating the method for forming a colored pattern of the present invention.

Fig. 2 is a schematic flow sheet illustrating the method for forming another colored pattern of the present invention.

### SUMMARY OF THE INVENTION

The present invention provides a photosensitive resin composition which comprises:
(a) a polysilane having a weight-average molecular weight of not less than 10000, which is soluble in an organic solvent;
(b) a combination of a photoradical generator and an oxidizing agent;
(c) a silicone oil having a chemical structure of the formula: 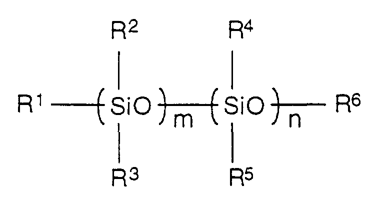 wherein R¹, R², R³, R⁴, R⁵ and R⁶ may be the same or different and indicate a group selected from the group consisting of an aliphatic hydrocarbon group having 1 to 10 carbon atoms which may be substituted with a halogen atom or a glycidyl group, an aromatic hydrocarbon group having 6 to 12 carbon atoms which may be substituted with a halogen atom, and an alkoxy group having 1 to 8 carbon atoms; and m and n indicate an integer satisfying an inequality of m + n ≥ 1; and
(d) an organic solvent.

The present invention provides a method for forming a colored pattern, which comprises the steps of:
(A) applying the photosensitive resin composition as described above on a substrate and drying the substrate to form a photosensitive layer;
(B) selectively exposing the photosensitive layer to light to form a latent image of the colored pattern; and
(C) coloring the exposed area in which the latent image of the colored pattern has been formed, using a coloring solution containing a dye or a pigment.

The present invention provides a method for forming a colored pattern, further comprising another coloring step (D) which is carried out at least one time according to the same manner as that of the coloring step except for forming a latent image of a different coloring pattern on the above photosensitive layer and using a different dye or pigment.

The present invention provides a method for forming a thin film pattern, which comprises the steps of:
(A') applying the photosensitive resin composition as described above on a substrate and drying the substrate to form a photosensitive layer;
(B') selectively exposing the photosensitive layer to light to form a patterned latent image; and
(C') dipping the exposed area in which the patterned latent image has been formed in a sol of a metal oxide, which does not contain a pigment or a dye, or applying the sol on the exposed area.

Thereby, the above object can be accomplished.

### DETAILED DESCRIPTION OF THE INVENTION

### <Photosensitive resin composition>

The photosensitive resin composition of the present invention contains (a) a polysilane having a weight-average molecular weight of not less than 10000, which is soluble in an organic solvent, (b) a combination of a photoradical generator and an oxidizing agent, (c) a silicone oil and (d) an organic solvent.

### (a)Polysilane

Examples of the polysilane to be used in the present invention include network type or chain type polysilanes. Taking a mechanical strength of the photosensitive material into consideration, the network type polysilane is preferred. The network type polysilane is distinguished from the chain type polysilane by a bonding state of Si atoms contained in the polysilane. The network type polysilane is a polysilane which contains Si atoms of which bonding number with adjacent Si atoms (bond number) is 3 or 4. The chain type polysilane has a bond number of 2. Since the valence of the Si atom is 4, Si atoms having a bond number of not more than 3 in the polysilane bond with a hydrocarbon group, an alkoxy group or a hydrogen atom, in addition to the adjacent Si atoms.

The hydrocarbon group may preferably be an aliphatic hydrocarbon group having 1 to 10 carbon atoms which may be substituted with a halogen atom or an aromatic hydrocarbon group having 6 to 14 carbon atoms. Examples of the aliphatic hydrocarbon groups are chain type hydrocarbon groups such as a methyl group, a propyl group, a butyl group, a hexyl group, an octyl group, a decyl group, a trifluoropropyl group, a nonafluorohexyl group, etc.; and alicyclic hydrocarbon groups such as a cyclohexyl group, a methylcyclohexyl group, etc. Examples of the aromatic hydrocarbon groups are a phenyl group, a p-tolyl group, a biphenyl group, an anthracyl group, etc.

Examples of the alkoxy groups are those having 1 to 8 carbon atoms, such as a methoxy group, an ethoxy group, a phenoxy group, an octyloxy group, etc. Among them, a methyl group or a phenyl group is particularly because they are easily producible.

In case of network type polysilane, the proportion of the Si atom having a bond number (with the adjacent Si atom) of 3 or 4 is preferably within a range of 5 to 50% based on the total number of Si atoms in the network type polysilane. When the proportion is less than 5%, the technical effect of the present invention is not obtained. On the other hand, when it exceeds 50%, the solubility is likely to be inferior. This value can be decided by measuring a nuclear magnetic resonance spectrum of silicon.

Further, the polysilane in the present invention also include those obtained by mixing the network and chain polysilanes. The proportion of the above Si atom in that case is calculated by an average of the network and chain polysilanes.

The polysilane to be used in the present invention can be produced by heating a silane halide compound to 80°C or more in an organic solvent (e.g. n-decane, toluene, etc.) in the presence of an alkali metal (e.g. sodium, etc.), i.e. polycondensation reaction.

The network type polysilane can be obtained by heating a halosilane mixture comprising an organotrihalosilane compound, a tetrahalosilane compound and a diorganohalosilane compound, wherein a proportion of the organotrihalosilane compound and tetrahalosilane compound is within a range of 5 to 50 molar % based on the total amount, to carry out polycondensation. The organotrihalosilane compound is a resource of an Si atom whose bond number (with the adjacent Si atom) is 3, while the tetrahalosilane compound is a resource of an Si atom whose bond number (with the adjacent Si atom) is 4. Further, the network structure can be confirmed by measuring a ultraviolet absorption spectrum or a nuclear magnetic resonance spectrum of silicon.

The chain type polysilane can be produced by the same reaction as that in case of the network type polysilane, except for using a plurality of diorganodichlorosilanes or a diorganodichlorosilane.

It is preferred that a halogen atom contained in the organotrihalosilane compound, tetrahalosilane compound and diorganohalosilane compound which are used as the raw material of the polysilane is a chlorine atom. Examples of the substituent other than the halogen atom, which is contained in the organotrihalosilane compound and diorganohalosilane compound, include the above mentioned hydrocarbon group, alkoxy group and hydrogen atom.

These network and chain type polysilanes may be anyone which are soluble in the organic solvent and have a weight-average molecular weight of not less than 10000. Taking the use as the photosensitive material into consideration, the polysilane to be used in the present invention must be soluble in a volatile organic solvent. Preferred examples of the organic solvent are hydrocarbons, hydrocarbon halides and ethers having 5 to 12 carbon atoms.

Examples of the hydrocarbons are pentane, hexane, heptane, cyclohexane, n-decane, n-dodecane, benzene, toluene, xylene, methoxybenzene, etc. Examples of the hydrocarbon halide are carbon tetrachloride, chloroform, 1,2-dichloroethane, dichloromethane, chlorobenzene, etc. Examples of ethers are diethyl ether, dibutyl ether, tetrahydrofuran, etc.

In addition, the weight-average molecular weight of the polysilane is preferably not less than 10000. When it is less than 10000, the technical effects of the present invention is not obtained.

### (b) Combination of photoradical generator and oxidizing agent

The photoradical generator which can be used in the present invention may be any compound which generates a halogen radical by light irradiation, and examples thereof are 2,4,6-tris(trihalomethyl)-1,3,5-triazine and a compound wherein the 2-position or 2- and 4-positions are substituted, phthalimidotriahalomethane sulfonate and a compound having a substituent on the benzene ring, naphthalimidotrihalometane sulfonate and a compound having a substituent on a benzene ring, etc. The substituent to be contained in these compounds is an optionally substituted aliphatic or aromatic hydrocarbon group.

On the other hand, the oxidizing agent which can be used in the present invention may be any compound which can be an oxygen supply source, and examples thereof are a peroxide, an amine oxide, a phosphine oxide, etc. A combination of trichlorotriazine as the photoradical generator and a peroxide as the oxidizing agent is preferred.

The addition of the photoradical generator and oxidizing agent utilizes the fact that the Si-Si bond is efficiently broken by a halogen radical and oxygen is easily incorporated thereto. Furthermore, it is also possible to generate a halogen radical due to photoexcitation of the dye by adding soluble dye such as cumarin dye, cyanine dye, merocyanine dye, etc. These are related to an improvement of sensitivity to light of the polysilane.

### (c) Silicone oil

The silicone oil to be used in the present invention is that represented by the formula: 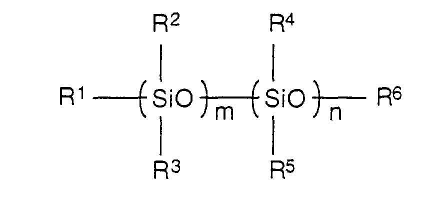 wherein R¹, R², R³, R⁴, R⁵ and R⁶ may be the same or different and indicate a group selected from the group consisting of an aliphatic hydrocarbon group having 1 to 10 carbon atoms which may be substituted with a halogen atom or a glycidyl group, an aromatic hydrocarbon group having 6 to 12 carbon atoms which may be substituted with a halogen atom, and an alkoxy group having 1 to 8 carbon atoms; and m and n indicate an integer and satisfy an inequality of m + n ≥ 1.

Examples of the aliphatic hydrocarbon group contained in the silicone oil are linear hydrocarbon groups such as a methyl group, a propyl group, a butyl group, a hexyl group, an octyl group, a decyl group, a trifluoropropyl group, a glycidyloxypropyl group, etc.; and alicyclic hydrocarbon groups such as a cyclohexyl group, a methylcyclohexyl group, etc. Examples of the aromatic hydrocarbon group are a phenyl group, a p-tolyl group, a biphenyl group, etc. Examples of the alkoxy group are a methoxy group, an ethoxy group, a phenoxy group, an octyloxy group, etc.

The kind of R¹ to R⁶ and value of m and n are not particularly important, and the silicone oil may be anyone which is liquid at room temperature and is compatible with the polysilane and organic solvent. Taking the compatibility into consideration, it is preferred to have the same group as that of the hydrocarbon group of the polysilane to be used. For example, when using a phenylmethyl polysilane, it is preferred to use the same phenylmethyl or diphenyl silicone oil. In addition, the silicone oil having two or more alkoxy groups in the molecule wherein at least two of R¹ to R⁶ indicate an alkoxy group having 1 to 8 carbon atoms can be used as a crosslinking agent. Examples thereof are methylphenylmethoxysilicone or phenylmethoxysilicone, which contains 15 to 35% by weight of an alkoxy group.

The silicone oil preferably has a weight average molecular weight of not more than 10,000, more preferably not more than 3,000. A lower limit of the silicone oil can be as low as 500. In addition, the silicone oil further has a viscosity at 25°C of not more than 200 mPa.s (cps), preferably not more than 50 mPa.s (cps). A lower limit of the viscosity can be as low as 1 mPa.s (cps).

### (d) Organic solvent

The organic solvent to be used in the present invention can be those described in the polysilane (a).

. Regarding the composition in the photosensitive resin composition of the present invention, an amount of the photoradical generator, oxidizing agent and silicone oil may be respectively 1 to 30 parts by weight, 1 to 30 parts by weight and 5 to 100 parts by weight, based on 100 parts by weight of the polysilane. When the dye is further added, an amount of the dye is preferably 1 to 20 parts by weight, based on 100 parts by weight of the polysilane. The organic solvent can be used such that a total concentration may is 5 to 15% by weight. In the present invention, since the silicone oil which functions as a compatibilizing agent for the polysilane and photoradical generator or oxidizing agent is used, it is possible to contain a large amount of the photoradical generator and oxidizing agent in comparison with the case using no silicone oil.

### <Photosensitive material>

The photosensitive material can be obtained by applying the above photosensitive resin composition on a substrate, followed by drying. The substrate varies depending on the use, and includes glass plate, metal plate or plastic plate. When a color filter is produced, a transparent substrate must be used. Examples of the transparent substrate include glass plate, quartz plate, polyethylene terephthalate film, polyolefin film, acrylic film, etc. It is particularly preferred to use glass plate as the substrate. In that case, a thickness of the substrate varies depending on the strength of the material to be used. For example, when using the glass plate, those having the thickness within a range of 0.6 to 1.2 mm are preferred in view of strength of the color filter material. In addition, a light-screen film (black matrix) of a metal chrome may be optionally patterned on the substrate.

The application method onto the substrate may be anyone which can form a polysilane layer having an uniform thickness, and the application can be carried out by the method known to persons skilled in the art. It is preferred to use a spin coating method, normally. It is preferred that the polysilane layer to be formed on the substrate has a dry film thickness within a range of 0.1 to 1.0 µm. The photosensitive material thus obtained can be used as a color filter or a ceramic thin film.

### <Method for forming colored pattern>

The method for forming a colored pattern of the present invention comprises the steps of applying the photosensitive resin composition on a substrate and drying the substrate to form a photosensitive layer (A), selectively exposing the photosensitive layer to light to form a latent image of the colored pattern (B) and coloring the exposed area in which the latent image of the colored pattern has been formed, using a coloring solution containing a dye or a pigment (C).

In addition, when the multi-colored pattern is formed, the method further comprise another coloring step (D) which is carried out at least one time according to the same manner as that of the coloring step except for forming a latent image of a different coloring pattern on the above photosensitive layer and using a different dye or pigment.

### Step (A)

This step is the same as that described in the item of the above photosensitive material

### Step (B)

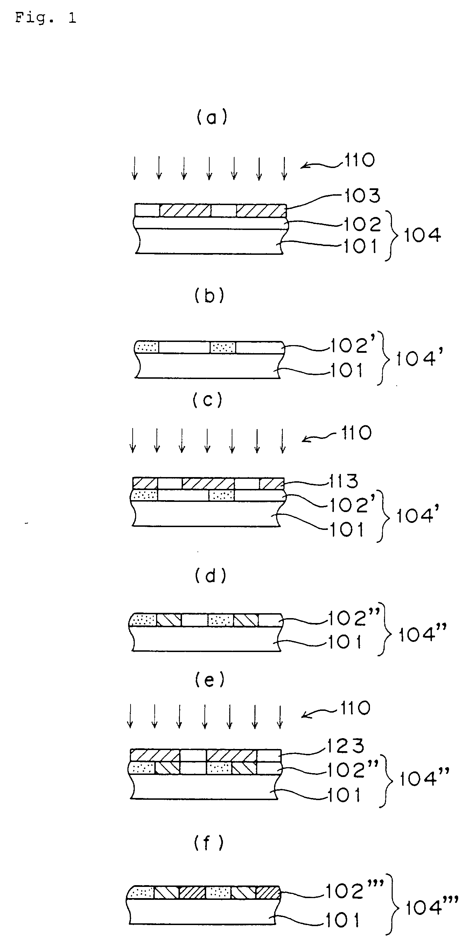

In the second step, the latent image of the colored pattern is formed on the exposed area by selectively exposing the above photosensitive layer to light. Ultraviolet light is normally used for the exposure. This step was shown in Fig. 1 (a). That is, a photo-mask **103** of the pattern is placed on the photosensitive material **104** of a substrate **101** and a polysilane layer **102,** which was obtained in the step (A), and ultraviolet light **110** is irradiated thereon.

The ultraviolet light to be used in the present invention has a wavelength of 250 to 400 nm within the σ-σ^{*} absorption range of the polysilane. This irradiation may be carried out at a light volume of 0.01 to 1 J/cm², preferably 0.1 to 0.5 J/cm² per 1 µm in thickness of the polysilane layer. When the light volume is smaller than 0.01 J/cm², coloring properties are deteriorated. On the other hand, when the light volume exceeds 1 J/cm², a large amount of pinholes are generated. The ultraviolet light resource can be high-pressure and ultra-high pressure mercury lamps, xenon lamps, metal halide lamps, etc. The laser scanning can be conducted by He-Cd laser, Ar laser, YAG laser, excimer laser, etc.

The Si-Si bond which exists in the polysilane layer is broken by ultraviolet irradiation to form Si-OH (silanol group). Accordingly, a latent image having a silanol group is formed in the irradiated photosensitive material according to the pattern.

### Step (C)

The third step is a step of coloring the exposed area in which the latent image of the coloring pattern has been formed, using a coloring solution containing a dye or a pigment. As the coloring method in this step, there can be used sol-gel coloring method, dyeing method, electrodeposition method and silane coupling method. In view of heat resistance of the resulting material, the sol-gel coloring or silane coupling method is preferred. Hereinafter, the sol-gel coloring method will be explained in detail.

### Sol-gel coloring method

In the sol-gel coloring method, a sol of a metal oxide, which contains a dye or a pigment, is used as a coloring solution. In the present specification, the term "metal oxide sol" means those obtained by subjecting one or more sorts of metals to polycondensation to form a sol in a suitable solvent.

As the raw material of the metal oxide sol, there can be used those which are normally used in the sol-gel method. Examples thereof are metal organic substances (e.g. alkoxide, acetylacetonate, acetate, amine, etc.), soluble inorganic salts (e.g. nitrate, etc.) or dispersants of fine oxide particles of metals. Examples of the metals are Si, Zr, Pb, Ti, Ba, Sr, Nb, K, Li, Ta, In, Sn, Zn, Y, Cu, Ca, Mn, Fe, Co, La, Al, Mg, V, and the like. It is preferred to use as the raw material an alkoxide of Si, which is easily handled. The sol formation can be carried out by dissolving the above raw material in a solvent such as alcohol to form a solution and subjecting the solution to polycondensation reaction using a catalyst such as acid or base.

When the metal oxide sol is synthesized using tetraethoxysilane as the alkoxide of Si, a mixture obtained by dissolving tetraethoxysilane in a mixed solution of ethanol and water was mixed with the dye or pigment, and hydrochloric acid was added, followed by stirring at room temperature. Thereby, tetraethoxysilane is hydrolyzed and condensed with dehydrating to give a homogeneous silica sol. In addition, the addition of the dye or pigment may be carried out after the sol was formed.

Regarding the composition, the amount of ethanol, water, hydrochloric acid and dye or pigment is preferably 20 to 200 parts by weight, 50 to 200 parts by weight, 0.01 to 3 parts by weight and 0.5 to 25 parts by weight, based on 100 parts by weight of tetraethoxysilane.

The dye or pigment which can be used in the present invention may be anyone which can be dissolved or dispersed in an alcohol solution of the metal alkoxide and has an interaction with the metal oxide sol. It is considered that such a dye or pigment is adsorbed in the photosensitive material by the interaction with a silanol group to be formed in the polysilane layer due to ultraviolet irradiation. As a result, the photosensitive material is colored according to the exposed pattern.

Examples of the dye include basic dye, oil-soluble dye and disperse dye. Examples of C.I. No of the dye which can be suitably used in the present invention will be shown below.

Examples of the basic dye are Basic Red 12, Basic Red 27, Basic Violet 7, Basic Violet 10, Basic Violet 40, Basic Blue 1, Basic Blue 7, Basic Blue 26, Basic blue 77 and Basic Green 1 and Basic Yellow 21.

Examples of the oil-soluble dye are Solvent Red 125, Solvent Red 132, Solvent Red 83, Solvent Red 109, Solvent Blue 67, Solvent Blue 25, Solvent Yellow 25, Solvent Yellow 89 and Solvent Yellow 146.

Examples of the disperse dye are Disperse Red 60, Disperse Red 72, Disperse Blue 56, Disperse Blue 60 and Disperse Yellow 60.

Among them, metal-containing oil-soluble dyes which are superior in heat resistance and light resistance are particularly suitable as the color filter.

Examples of C.I. No. of the pigment which can be suitably used in the present invention include Pigment Yellow 83, Pigment Yellow 110, Pigment Yellow 139, Pigment Red 53:1, Pigment Red 177, Pigment Red 221, Pigment Violet 23, Pigment Violet 37, Pigment Blue 15, Pigment Blue 15:3, Pigment Blue 15:6, Pigment Green 7, Pigment Green 36 and Pigment Black 7.

The pigment may be converted into a sol or dispersed in the sol solution after it was once dispersed in the alcohol solution of the metal alkoxide. In case of dispersion, it is preferred to disperse in a particle size smaller than the visible wavelength using a nonionic surfactant.

The exposed area of the photosensitive material is colored by applying the metal oxide sol containing the dye or pigment, or dipping it in the sol. This is considered as follows. That is, the silanol group is formed on the exposed area of the photosensitive material, as described above, and an adsorption (gelation) due to the interaction between this silanol group and metal oxide sol containing the dye or pigment arises. In addition, it is possible to confirm by a transmission electron microscope that particles of the metal oxide are adsorbed on the pigment surface in the metal oxide sol in which the pigment is dispersed and, at the same time, the pigment is present in the interior of the photosensitive layer when the coloring is carried out using the metal oxide sol in which the pigment is dispersed. Thereby, it is possible to confirm that the pigment in which particles of the metal oxide are absorbed on the surface is diffusing into the interior through micropore which are present at the exposed area of the photosensitive layer.

The application can be carried out using air spray, airless spray, roll coater, curtain flow coater, meniscus coater, etc. On the other hand, the dipping is carried out by charging the coloring solution in a tank having a size enough to completely dip the photosensitive material. The method due to application is preferred because the coloring solution is easily controlled and the amount of the coloring solution is small.

In order to increase the coloring speed and coloring concentration, it is possible to add an aprotic organic solvent (e.g. acetonitrile, dioxane, tetrahydrofuran, etc.) which enables swelling of the polysilane layer in the metal oxide sol. These aprotic organic solvents can be preferably contained in the amount of 1 to 20% by weight in the metal oxide sol. When the amount of the solvent exceeds 20% by weight, a partial redissolution of the polysilane layer is likely to arise to cause a turbulence on the surface of the resulting colored photosensitive material.

The colored photosensitive material thus obtained is dried after the metal oxide sol containing the dye or pigment was removed. As the method of removing, there can be used a method of washing with water, a method of blowing off using an air blow, etc.

It is preferred to dry at 100°C or more for 10 minutes to one hour, but the drying condition can vary within a range where no harmful influence is exerted on the transparent electrode, dye and pigment to be used. For example, when the glass plate is used as the transparent substrate and the pigment is contained, it is possible to dry at 200°C for 30 minutes or more. In this drying process, it is predicated that the gelation due to the dehydration reaction further proceed to become the situation where the dye or pigment is trapped in the crosslinked film of SiO₂. Particularly, when using those having two or more alkoxy groups in the molecule as the silicone oil, the crosslinking action proceeds and the heat resistance of the resulting colored pattern area is improved.

Thereby, there can be obtained a colored film having an excellent resistance, which is not easily eluted in the organic solvent and is not colored in another coloring step.

As shown in Fig. 1 (b), a pattern single-colored photosensitive material 104' is obtained by the first pattern coloring step.

### Coloring method other than sol-gel coloring method

As the coloring method other than the sol-gel coloring method, there can be dyeing method, electrodeposition method and silane coupling method.

In the dyeing method, the exposed area of the photosensitive material is colored by applying an aqueous solution of the dye as the coloring solution or dipping it in the solution. This is considered that the dye is adsorbed by the interaction with the silanol group formed at the exposed area. It is preferred that the aqueous solution of the dye contains 0.1 to 5% by weight of the dye. As the dye, there can be used those which were described in the sol-gel coloring method. In addition, 1 to 30% by weight of a lower alcohol may be added so as to increase the solubility of the dye, and the aprotic organic solvent as that described in the sol-gel coloring method can be contained. The dyeing conditions such as dyeing temperature, dyeing time, etc. can vary depending on the desired dye concentration as well as kind and amount of the dye to be used. The dyed photosensitive material is dried after the aqueous solution of the dye was removed. As the method of removing, there can be used a method of washing with water and a method of blowing off using an air blow, similar to the sol-gel coloring method. The drying may be carried out by standing at room temperature, but is preferably carried out forcibly by heating at 50 to 100°C for 5 to 30 minutes.

In the electrodeposition method, an electrodepositable solution containing the dye or pigment is used as the coloring solution. As the electrodepositable solution, there can be used an anionic or cationic resin and a micelle electrolyte, which are well known to persons skilled in the art.

The anionic resin is that obtained by neutralizing a resin having an acid group with a base. As the resin, a (meth)acrylic acid copolymer and an oil-free polyester resin are preferred. To the contrary, the cationic resin is that obtained by neutralizing a resin having an basic group with an acid. As the resin, a (meth)acrylate copolymer is preferred.

On the other hand, the micelle electrolyte is an aqueous micelle solution of a charged surfactant. As the surfactant, positively or negatively charged one is preferred, and examples of the positively charged one include benzalkonium chloride, lanolin fatty acid aminopropylethyldimethylammonium salt, tetraalkylammonium salt, imidazolinium salt, alkyldimethylbenzylammonium salt, etc. Examples of the negatively charged one include aliphatic carboxylate salt, alkylbenzenesulfonate salt, sulfosuccinate salt, etc.

As the dye and pigment, which can be used in the electrodeposition method, there are dyes such as direct dye and acid dye, in addition to those described in the sol-gel coloring method. Examples of the direct dye include Direct Yellow 44, Direct Red 23, Direct Red 79, Direct Blue 25, Direct Blue 86, Direct Green 59, etc.

Examples of the acid dye include Acid Yellow 38, Acid Yellow 99, Acid Violet 49, Acid Blue 40, Acid Blue 83, Acid Green 25, Acid Green 18, etc.

The electrodepositable solution containing the dye or pigment can be produced as follows. That is, in case of the anionic or cationic resin, the objective coloring solution can be obtained by neutralizing a resin having an acid or basic group to prepare an aqueous solution or a water dispersion, and then dissolving a dye or a pigment in the solution or dispersion. When using the pigment, it is preferred to disperse so that the particle size may become not more than 0.4 µm. Thereafter, the dispersion is diluted with water so that the pigment concentration may become 3 to 20% and a solvent is optionally added to obtain an electrodepositable solution. Furthermore, a thermosetting electrodepositable solution can also be prepared by adding an amino resin and blocked isocyanate, which are known to a curing agent for electrodeposition coating composition. In addition, a silane coupling agent and colloidal silica may also be contained in the electrodepositable solution in order that a crosslinked structure is formed by reacting with the silanol group formed at the ultraviolet irradiated area of the polysilane. On the other hand, in case of water-soluble dye, the dispersion step is not required. In case of oil-soluble dye and disperse dye, however, it is necessary to carry out atomization by dispersion, similar to the case of pigment.

To the contrary, in case of micelle electrolyte, the coloring solution is prepared by adding the above surfactant and dye or pigment in an aqueous medium and optionally dispersing. The concentration of the surfactant is not specifically limited, but is preferably a critical micelle concentration or more. In addition, in order to form a crosslinked structure of the polysilane layer with the silanol group, the above silane coupling agent and colloidal silica ca be used in combination. In order to adjust the conductivity, a supporting electrolyte such as sulfate or acetate salt of alkali metals may be optionally added.

In the electrodeposition method, it is necessary to use a glass plate in which a transparent electrode has been formed using ITO, conductive polymer, etc. as the transparent substrate, unlike other coloring method. The glass plate in which the transparent has been formed by way of the above steps (A) and (B) is dipped in the above electrodepositable solution. A colored pattern is formed on the polysilane layer of the latent image by electrodepositing using the transparent electrode as a cathode or an anode.

When the resin used for the electrodepositable solution has a crosslinking capability, the drying may be carried out according to the crosslinking reaction condition. When the resin used for the electrodepositable solution has no crosslinking capability or the solution contains no resin and is composed of the pigment and surfactant, it is preferred to dry at 80°C for 10 minutes or more.

The last coloring method is a silane coupling method. In this method, an aqueous pigment dispersion containing a silane coupling agent is used as the coloring agent. As the silane coupling agent, there can be used those known to public, but it is preferred to use methoxysilane and ethoxysilane coupling agents. As the pigment, there can be used those described in the sol-gel coloring method.

The aqueous pigment dispersion containing the silane coupling agent is prepared by dispersing 1 to 25 parts by weight of an nonionic surfactant, 1 to 25 parts by weight of a silane coupling agent, water and 150 to 250 parts by weight of an optional organic solvent, based on 100 parts by weight of a pigment, using glass beads. Normally, the silane coupling reaction proceeds in the presence of the acid and, therefore, it is preferred to make the coloring solution acid, using hydrochloric acid.

The silane coupling reaction proceeds by applying the aqueous pigment dispersion containing this silane coupling agent to the exposed photosensitive material or dipping it in the dispersion, removing the coloring solution, followed by drying, thereby coloring according to the exposed pattern. The other details are the same as those described in the sol-gel coloring method.

### Step (D)

The photosensitive material is colored with a single color by the above steps (A) to (C). In order to obtain a material with a plurality of colors, such as color filter, additional different coloring is required. Therefore, in the fourth step, the photosensitive material which is colored with a single color obtained by the steps (A) to (C) is subjected to the second coloring or following coloring.

As shown in Fig. 1 (c), according to the same manner as that described in the above steps (B) and (C) except for forming a latent image of a different colored pattern on the polysilane layer using a mask film **113** in place of the mask film 103 and using a dye or pigment which is different from that used above, a photosensitive material **104**" which is pattern colored with two colors is obtained, as shown in Fig. 1 (d). Normally, as shown in Fig. 1 (c), the mask film **113** to be used here has a mask pattern which covers the pattern area of the polysilane layer colored in the above steps (B) and (C) to expose the non-colored area to light.

As shown in Fig. 1 (e), according to the same manner as that described in the second coloring step except for forming a latent image of a different colored pattern on the polysilane layer using a mask film **123** in place of the mask film **113** and using a different dye or pigment, a photosensitive material **104**"' which is pattern colored with three colors is obtained, as shown in Fig. 1 (f). Normally, as shown in Fig. 1 (e), the mask film **123** to be used here has a mask pattern which covers the colored pattern area of the first and second coloring of the polysilane layer to expose the non-colored area to light.

It is possible to make a filter which is pattern colored with multi-colors by repeating such a step. In addition, it is possible to carry out coloring of the area other than the colored pattern area of the first coloring by exposing the whole surface to light without using a mask film.

Further, the term "form a latent image of a different colored pattern" in the present specification means that a latent image of all the same colored pattern is not formed in the respective pattern coloring steps, but it is not necessarily limited to the fact that the colored pattern is formed without overlapping. In addition, the term "use a different dye or pigment" in the present specification means to use a coloring solution having a different hue which contains at least one sort of a dye or pigment in the respective pattern coloring steps. At least one part of the dye or pigment composition to be used for the coloring solution may overlap in the respective steps.

Since the patterned area of the polysilane layer which was once colored and dried has hardly any silanol group, it is hardly dyed with the other dye or pigment in the following coloring step. Accordingly, a problem of color mixing hardly arise in the method of the present invention. When the dyeing method is used as the coloring method, it is preferred to carry out coloring using a dye in the order of the rapid adsorption speed so as to surely prevent color mixture of the colored pattern. The adsorption speed of the dye which can be used in the present invention is decided by a silica gel chromatography. On the other hand, as the method of preventing color mixture when the electrodeposition method is used as the coloring method and the micelle electrolyte is used as the coloring solution, there can be used a method comprising measuring an oxidation potential of the pigment to be used using a voltametry and coloring using the pigment having high oxidation potential, firstly.

### <Color filter>

The color filter of the present invention can be obtained by using three-color colorants containing a dye or pigment corresponding to the three primary colors RGB in the method for forming a colored pattern, comprising the above steps (A) to (D), and further forming a black matrix or a black stripe. This black matrix and black stripe can be colored using a black dye or black pigment as the fourth color after the three primary colors RGB. In addition, a transparent substrate in which the black matrix or black stripe is previously patterned may be used.

### <Method for forming thin film pattern>

The method for forming a thin film pattern of the present invention comprises the steps of applying the photosensitive resin composition on a substrate and drying the substrate to form a photosensitive layer (A'), selectively exposing the photosensitive layer to light to form a patterned latent image (B'), and dipping the exposed area in which the patterned latent image has been formed in a sol of a metal oxide, which does not contain a pigment or a dye, or applying the sol on the exposed area (C').

### Steps (A') and (B')

These two steps are the same as those of the steps (A) and (B) of the above method for forming the colored pattern.

### Step (C')

In this step, the exposed area in which the patterned latent image has been formed is dipped in a sol of a metal oxide, or applying the sol on the exposed area. It is quite different from the step (C) of the above method for forming the colored pattern in the respect that the sol of the meal oxide to be used here contains no pigment or dye. As the sol of the metal oxide, there can be used those described in the sol-gel method of the step (C) of the method for forming the colored pattern.

A pattern is formed by dipping the above exposed area in the sol of the metal oxide, or applying the sol on the exposed area. As described above, it is considered that adsorption (gelation) due to the interaction between the silanol group formed at the exposed area and metal oxide sol particle arises.

In addition, when a functional moiety or a functional compound is contained in the metal oxide sol, the moiety or compound is incorporated into the interior of the photosensitive layer as the metal oxide sol is adsorbed and, therefore, a thin film having a function is obtained.

When the function is developed by adsorption, the following three cases are considered. The first case is that the metal oxide sol particles themselves contain a functional atom or a functional group. The second case is that a functional particulate material, which can be adsorbed in the photosensitive layer together with the metal oxide sol particles, coexists. The last case is that a functional material, which can be dissolved in the metal oxide sol, coexists. As a matter of course, the function may be developed by using these cases in combination.

Examples of the functional atom include fluorine atom. Examples of the functional group include hydrophobic groups such as alkyl group, etc.; and groups having ion exchange properties, such as carboxyl group, sulfo group, acidic hydroxyl group, amino group, etc. For example, when using the fluorine atom, the hydrophobic moiety can be patterned on the photosensitive layer by forming a sol containing a large amount of these functional atoms or functional groups to adsorb the sol in the photosensitive layer.

Examples of the functional particulate material include copper and silver particles. When using silica gel as the metal oxide sol, silica sol particles can coexist with the functional particulate material by dispersing the functional particulate material using a silica sol or mixing those, which was once dispersed using a nonionic surfactant, at the time of preparing the silica sol. In this case, it is necessary that the particle size of the functional particulate material is adjusted to not more than 500 nm, preferably not more than 200 nm. When the particle size exceeds 500 nm, the particles can not be diffused into the irradiated area of the photosensitive layer even if it is dipped in the sol solution and, therefore, it cannot be sticked. The particle size can be normally measured by a centrifugal sedimentation method. It is considered that silica sol particles are adsorbed on the surface of the functional particulate material when the silica sol particles coexist with the functional particulate material. The adsorption of silica sol particles onto the surface of functional particles can be confirmed by measuring the zeta potential. For example, the zeta potential when dispersing using a nonionic surfactant is stabilized within a range of -5 to -25 mV. It is considered that the silanol group exists on the surface of the functional particulate material due to the adsorption of the silica sol. Copper and silver can be patterned and contained in the photosensitive layer by adsorbing the material thus produced in the photosensitive layer.

On the other hand, as the functional material which can be dissolved in the metal oxide sol, there can be used those which are dissolved in water or alcohol and have properties of interacting with the silanol group of the silica sol. Suitable examples of the functional material include polymers having an alcoholic hydroxyl group, such as polyvinyl alcohol, polyethylene glycol, cellulose, etc.; and amide group-containing polymers such as poly(2-methyl-2-oxazoline), poly(N-vinylpyrrolidone), poly(N,N-dimethylacrylamide), etc. When these materials are contained in the photosensitive layer, various functions can be imparted. For example, the flexibility can be imparted by gelling at the temperature where the material is not decomposed. In addition, the porosity can be imparted by gelling at the temperature higher than that where the material is decomposed and making use of holes remained after the material was decomposed.

The application can be carried out using air spray, airless spray, roll coater, curtain flow coater, meniscus coater, etc. On the other hand, the dipping is carried out by charging the metal oxide sol solution in a tank having a size enough to completely dip the photosensitive material. The method due to application is preferred because the solution is easily controlled and the amount of the sol solution is small.

In order to increase the adsorbing speed and patterning concentration, it is possible to add an aprotic organic solvent (e.g. acetonitrile, dioxane, tetrahydrofuran, etc.) which enables swelling of the polysilane layer in the metal oxide sol. These aprotic organic solvents can be preferably contained in the amount of 1 to 20% by weight in the metal oxide sol. When the amount of the solvent exceeds 20% by weight, a partial redissolution of the polysilane layer is likely to arise to cause a turbulence on the surface of the resulting patterned photosensitive material.

The patterned photosensitive material thus obtained is dried after the metal oxide sol solution was removed. As the method of removing, there can be used a method of washing with water, a method of blowing off using an air blow, etc.

It is preferred to dry at 100°C or more for 10 minutes to 2 hours, but the drying condition can vary within a range where no harmful influence is exerted on the substrate to be used and functional material to be contained. For example, when the metal oxide sol is a silica sol and the glass substrate is used, the organic substituent is eliminated by drying at 400°C or more to obtain a metal oxide thin film.

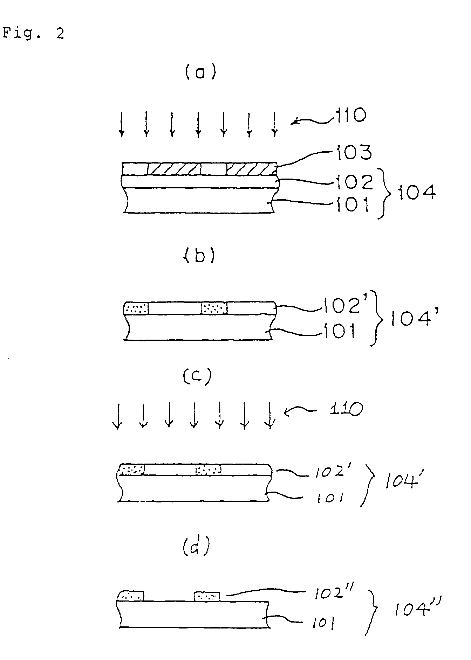

As shown in Fig. 2 (b), a desirably patterned laminate 104' for forming a thin film is obtained by the steps (A') to (C'). When the irregularities are required on the glass surface, like a pre-groove of an optical disc substrate, a pattern having irregularities can be obtained, as shown in Fig. 2 (d), by exposing the whole surface to light and decomposing the remained photosensitive layer to remove as shown in Fig. 2 (c). As the method of removing an unnecessary photosensitive layer, there can be used a method of evaporating by heating and a method of removing using a solvent. In case of method of removing by heating, it is sufficient to heat at 200°C or more for 10 to 60 minutes. In this case, metal oxide sol particles may not have functional characteristics.

In addition, thin films of different function can be easily patterned on the same substrate if the steps of (B') to (C') are repeated by changing the exposure area and using metal oxide sol solutions of different formulation.

Since the photoreactivity of the photosensitive resin composition was extremely improved in comparison with a conventional polysilane composition, the exposure time was shorten. Therefore, it became possible to increase the productivity of a color filter, and a functional patterning material.

### EXAMPLES

The following Preparation Examples, Examples and Comparative Examples further illustrate the present invention in detail but are not to be construed to limit the scope thereof.

### Preparation Example 1

### Preparation of straight-chain type polysilane

To a 1000 ml flask equipped with a stirrer, 400 ml of toluene and 13.3 g of sodium were charged. Sodium was finely dispersed in toluene by heating the contents of the flask to 111°C in a yellow room where ultraviolet light was cut-off, followed by vigorous stirring. Then, 51.6 g ofphenylmethyldichloro-silane was added and the mixture was polymerized by stirring for 3 hours. Thereafter, an excess amount of sodium was deactivated by adding ethanol to the resulting reaction mixture. After washing with water, the separated organic layer was introduced into ethanol to precipitate a polysilane. The resulting crude polysilane was reprecipitated three times from ethanol to give a straight-chain polymethylphenylsilane having a weight-average molecular weight of 24000.

### Preparation Example 2

### Preparation of network type polysilane

According to the same operation as that described in Preparation Example 1 except for changing the amount of phenylmethyldichlorosilane from 51.6 g to 42.1 g and further adding 4.1 g of tetrachlorosilane, a network polymethylphneylsilane having a weight-average molecular weight of 11600 was obtained.

### Example 1

### Production 1 of photosensitive resin composition and photosensitive material using the same

100 Parts by weight of the straight-chain type polysilane obtained in Preparation Example 1, 10 parts by weight of TSR-165 (methylphenylmethoxysilicone having a molecular weight of 930, manufactured by Toshiba Silicone Co., Ltd.), 10 parts by weight of TAZ-110 (2,4-bis(trichloromethyl)-6-(p-methoxyphenylvinyl)-1,3,5-triazine, manufactured by Midori Kagaku Co., Ltd.) and 15 parts by weight of BTTB (3,3',4,4'-tetra-(t-butylperoxycarbonyl)benzophenone, manufactured by NOF Corporation) were dissolved in 1215 parts by weight of toluene to give a photosensitive resin composition. This photosensitive resin composition was spin-coated on a quartz substrate so that absorption (at 335 nm) of the ultraviolet area of the polysilane may become 1.5 in absorbance to obtain a photosensitive material.

### Example 2

### Production 2 of photosensitive resin composition and photosensitive material using the same

According to the same operation as that described in Example 1 except for changing the amount of TSR-165 from 10 parts by weight to 30 parts by weight and changing the amount of toluene from 1215 parts by weight to 1395 parts by weight, a photosensitive resin composition and a photosensitive material were obtained.

### Example 3

### Production 3 of photosensitive resin composition and photosensitive material using the same

According to the same operation as that described in Example 1 except for changing the amount of TSR-165 from 10 parts by weight to 50 parts by weight and changing the amount of toluene from 1215 parts by weight to 1615 parts by weight, a photosensitive resin composition and a photosensitive material were obtained.

### Example 4

### Production 4 of photosensitive resin composition and photosensitive material using the same

According to the same operation as that described in Example 1 except for changing the amount of TSR-165 from 10 parts by weight to 100 parts by weight and changing the amount of toluene from 1215 parts by weight to 2115 parts by weight, a photosensitive resin composition and a photosensitive material were obtained.

### Example 5

### Production 5 of photosensitive resin composition and photosensitive material using the same

According to the same operation as that described in Example 1 except for using 10 parts by weight of X-40-2171 (phenylmethoxysilicone having a molecular weight of 790, manufactured by Shinetsu Kagaku Co., Ltd.) in place of 10 parts by weight of TSR-165, a photosensitive resin composition and a photosensitive material were obtained.

### Example 6

### Production 6 of photosensitive resin composition and photosensitive material using the same

According to the same operation as that described in Example 1 except for using 10 parts by weight of KR-213 (methylphenylmethoxysilicone having a molecular weight of 640, manufactured by Shinetsu Kagaku Co., Ltd.) in place of 10 parts by weight of TSR-165, a photosensitive resin composition and. a photosensitive material were obtained.

### Comparative Example 1

A solution obtained by dissolving 100 parts by weight of the straight-chain type polysilane obtained in Preparation Example 1 in 900 parts by weight of toluene was spin-coated on a quartz substrate so that absorption (at 335 nm) of the ultraviolet area of the polysilane may become 1.5 in absorbance to obtain a photosensitive material.

### Comparative Example 2

According to the same operation as that described in Example 1 except for using no TSR-165 and changing the amount of toluene from 1215 parts by weight to 1115 parts by weight, a photosensitive material was obtained.

### Evaluation of sensitivity of photosensitive material

Ultraviolet light was irradiated using an ultra-high pressure mercury lamp CL-50-200A (500 W) manufactured by Japan Storage Battery Co., Ltd. Then, the time which is necessary for the absorbance (at 335 nm) of the polysilane to be reduced to half of the value of the absorbance before irradiation (0.75) was measured and this value was taken as a sensitiveness. Further, a spectrophotometer MCPD-1000 manufactured by Ohtsuka Denshi Co., Ltd. was used for the measurement of the absorbance. The results are shown in Table 1.

**Table 1**

| Example | Silicone | Amount of silicone | Sensitivity (s) |
|---|---|---|---|
| Example 1 | TSR-165 | 10 | 12 |
| Example 2 | TSR-165 | 30 | 10 |
| Example 3 | TSR-165 | 50 | 8 |
| Example 4 | TSR-165 | 100 | 6 |
| Example 5 | X-40-2171 | 50 | 6 |
| Example 6 | KR-213 | 50 | 5 |
| Comparative Example 1*¹ | - | - | 60 |
| Comparative Example 2 | - | - | 15 |

| | | | |
|---|---|---|---|
| *1: Only polysilane | | | |

### Example 7

### Production 7 of photosensitive resin composition and photosensitive material using the same

100 Parts by weight of the straight-chain type polysilane obtained in Preparation Example 1, 50 parts by weight of TSR-165 (methylphenylmethoxysilicone having a molecular weight of 930, manufactured by Toshiba Silicone Co., Ltd.), 10 parts by weight of TAZ-110 (2,4-bis(trichloromethyl)-6-(p-methoxyphenylvinyl)-1,3,5-triazine, manufactured by Midori Kagaku Co., Ltd.), 15 parts by weight of BTTB (3,3',4,4'-tetra-(t-butylperoxycarbonyl)benzophenone, manufactured by NOF Corporation) and 5 parts by weight of 3,3'-carbonylbis(7-diethylaminocumarin) (manufactured by Kodak Co.) were dissolved in 1620 parts by weight of tetrahydrofuran to give a photosensitive resin composition. This photosensitive resin composition was spin-coated on a quartz substrate so that absorption (at 335 nm) of the ultraviolet area of the polysilane may become 1.5 in absorbance to obtain a photosensitive material. Ultraviolet light was irradiated on this photosensitive material. As a result, the time which is necessary for the absorbance (at 335 nm) of the polysilane to be reduced to half of the value of the absorbance before irradiation (0.75) was 45 seconds. Further, the ultraviolet irradiation was carried out by cutting off light having a wavelength of not more than 440 nm through a filter, using an ultra-high pressure mercury lamp CL-50-200A (500 W) manufactured by Japan Storage Battery Co., Ltd. A spectrophotometer MCPD-1000 manufactured by Ohtsuka Denchi Co., Ltd. was used for the measurement of the absorbance.

### Comparative Example 3

The same operation as that described in Example 7 except for using no TSR-165 and changing the amount of tetrahydrofuran from 1625 parts by weight to 1175 parts by weight was carried out. In this case, the time which is necessary for the absorbance (at 335 nm) of the polysilane to be reduced to half of the value of the absorbance before irradiation was 110 seconds.

### Comparative Example 4

The same operation as that described in Example 7 except for using no TSR-165 and 3,3'-carbonylbis(7-diethylaminocumarin) and changing the amount of tetrahydrofuran from 1620 parts by weight to 1130 parts by weight was carried out. In this case, the time which is necessary for the absorbance (at 335 nm) of the polysilane to be reduced to half of the value of the absorbance before irradiation was 460 seconds.

The silicone oil was used in the present invention for the purpose of compatibilizing the polysilane with the photoradical generator and oxidizing agent. As a result, the improvement of the photoreactivity due to the addition of the silicone oil was confirmed. The mechanism is considered as follows, assuming from the known fact that the photoreaction of the polysilane in the solution is several times to several tens times fast as that in a solid. That is, the polysilane layer is softened by containing the silicone oil. After softening, the reaction in the solid is similar to the reaction in the solution, thereby increasing the photoreactivity.

### Preparation Example 3

### Preparation of coloring solution to be used for sol-gel coloring method

Tetraethoxysilane (168 g), methyltriethoxysilane (84 g), deionized water (250 g) and ethanol (96 g) were charged in a 1000 cm³ beaker, and 35% concentrated hydrochloric acid (1.92 g) was added with stirring using a magnetic stirrer. The mixture was stirred for 15 minutes while maintaining the liquid temperature at 20°C. As a result, a transparent and homogeneous silica sol was obtained. This silica sol (56 g), deionized water (139 g) and Red AQ-866 (50 g, manufactured by Mikuni Shikiso Co., Ltd.) as a nonionic pigment paste for color filter were charged in a 300 cc beaker and, after stirring for 30 minutes, ethanol (40 g) was added to prepare a sol for red coloring.

In addition, Green AQ-016 (manufactured by Mikuni Shikiso Co., Ltd.), Blue AQ-010 (manufactured by Mikuni Shikiso Co., Ltd.) and Black AQ-022 (manufactured by Mikuni Shikiso Co., Ltd.) were used in place of red AQ-866 to prepare sol for green coloring, blue coloring and black coloring, respectively.

### Preparation Example 4

### Preparation of coloring solution to be used for dyeing method

Victoria Blue BH (2 g, basic dye manufactured by Hodagaya Kagaku Co., Ltd.), deionized water (178 g) and acetonitrile (20 g) were mixed to prepare a blue dyeing solution. Astrafloxine FF (2 g, basic dye manufactured by Hodogaya Chemical Co., Ltd.), deionized water (178 g) and acetonitrile (20 g) were mixed to prepare a red dyeing solution. Brilliant Basic Cyanine 6GH (1 g, basic dye manufactured by Hodogaya Chemical Co., Ltd.) and Yellow 7GLH (1.4 g, basic dye manufactured by Hodagaya Kagaku Co., Ltd.) were mixed to prepare a green dyeing solution.

It was confirmed by silica gel chromatography that the adsorption speed of the resulting three sorts of dyeing solutions is large in the order of blue, red and green.

### Preparation Example 5

### Preparation of coloring solution to be used for electrodeposition method

A mixture of Cl Pigment Red 177 (80 g), Cl Pigment Yellow 83 (20 g), polycarboxylic acid surfactant Carribon B (30 g, manufactured by Sanyo Kasei Co., Ltd.) and deionized water (300 g) was dispersed for 10 hours using a sand mill. Deionized water was added to the dispersion after filtration under pressure so that the pigment concentration may become 10%. Furthermore, acetonitrile was added so that the amount thereof may become 10% based on the total amount to prepare an electrodeposition solution for red coloring. An electrodeposition solution for green coloring was prepared using Cl Pigment Green 36 (80 g) and Cl Pigment Yellow 83 (20 g) as the pigment according to the same manner as described above. In addition, an electrodeposition solution for blue coloring was prepared using Cl Pigment Blue 15 (80 g) and Cl Pigment Violet 23 (20 g) as the pigment according to the same manner as described above. In addition, an electrodeposition solution for black coloring was prepared using Cl Pigment Black 7 (100 g) as the pigment according to the same manner as described above.

### Preparation Example 6

### Preparation of coloring solution to be used for silane coupling coloring method

A mixture of Cl Pigment Red 177 (80 g), Cl Pigment Yellow 83 (20 g), nonionic surfactant Nonipol 300 (30 g, manufactured by Sanyo Kasei Co., Ltd.), silane coupling agent KBM-403 (20 g), manufactured by Shin-Etsu Chemical Co., Ltd. and deionized water (300 g) was dispersed for 10 hours using a sand mill. Deionized water was added to the dispersion after filtration under pressure so that the pigment concentration may become 3.5%. Furthermore, acetonitrile was added so that the amount thereof may become 10% based on the total amount and the pH was adjusted to 2.5 using hydrochloric acid to prepare a red coloring solution. A green coloring solution was prepared using Cl Pigment Green 36 (80 g) and Cl Pigment Yellow 83 (20 g) as the pigment according to the same manner as described above.

In addition, a blue coloring solution was prepared using Cl Pigment Blue 15 (80 g) and CI Pigment Violet 23 (20 g) as the pigment according to the same manner as described above. In addition, a black coloring solution was prepared using CI Pigment Black 7 (100 g) as the pigment according to the same manner as described above.

### Example 8

### Production 1 of photosensitive resin composition for forming colored pattern and photosensitive material using the same

100 Parts by weight of the network type polysilane obtained in Preparation Example 2, 50 parts by weight of TSR-165 (methylphenylmethoxysilicone having a molecular weight of 930, manufactured by Toshiba Silicone Co., Ltd.), 10 parts by weight of TAZ-110 (2,4-bis(trichloromethyl)-6-(p-methoxyphenyl-vinyl)-1,3,5-triazine, manufactured by Midori Kagaku Co., Ltd.) and 15 parts by weight of BTTB (3,3',4,4'-tetra-(t-butylperoxycarbonyl)benzophenone, manufactured by NOF Corporation) were dissolved in 1575 parts by weight of toluene to give a photosensitive resin composition for forming colored pattern. This photosensitive resin composition for forming colored pattern was spin-coated on a glass substrate (5 cm x 5 cm) for liquid crystal display, followed by drying at 80°C for 10 minutes to obtain a photosensitive material having a film thickness of 2.0 µm.

### Example 9

### Production of color filter using sol-gel coloring method

A negative mask 76 mm x 76 mm (3 inch x 3 inch) in which a pixel pattern for red color filter (90 µm x 90 µm) was formed was put on the photosensitive material obtained in Example 8, and a laminate thus obtained was exposed to ultraviolet light at a light volume of 0.2 J/cm² using an ultra-high pressure mercury lamp. After the negative mask was removed, the filter material in which a latent image was formed was dipped in the coloring sol solution for red obtained in Preparation Example 3 for 2 minutes. Thereafter, it was washed with water and dried at 100°C for 10 minutes.

Then, a negative mask in which a pixel pattern for blue color filter was formed was put on the position which is 20 µm away from the red pixel in the horizontal direction, in place of the negative mask used above, and the resulting laminate was exposed to give a latent image. After the formation of the latent image, the second coloring was carried out using the coloring sol for blue obtained in Preparation Example 3 according to the same operation as that described in the red coloring. According to the same manner as that described above except for using a negative mask in which a pixel pattern for green color filter was formed and using a coloring sol for green obtained in Preparation Example 3, the third coloring was carried out. Finally, the laminate was exposed to light without using a negative mask to expose the non-exposed area of 20 µm in width, which was present between the respective color pixels. The coloring was carried out using the sol for black coloring obtained in Preparation Example 3 to form a light-screen film between pixels, thereby obtaining a color filter.

It was confirmed that no color mixture is observed in the resulting color filter. In addition, a spectral transmittance of the color filter was measured using a spectrophotometer MCPD-1000 manufactured by Ohtsuka Denshi Co., Ltd. The results are as follows: R: 5% (wavelength: 510 nm), G: 8% (wavelength: 450 nm), 7% (wavelength: 650 nm), B: 4% (wavelength: 600 nm).

### Comparative Example 5

According to the same operation as that described in Example 8 except for using no TSR-165 and changing the amount of toluene from 1575 parts by weight to 1115 parts by weight, a photosensitive material was obtained. According to the same operation as that described in Example 9 except for using the photosensitive material obtained here in place of the photosensitive material obtained in Example 8, a color filter was obtained but the colored state was insufficient. The spectral transmittance of the color filter was as follows: R: 32% (wavelength: 510 nm), G: 36% (wavelength: 450 nm), B: 23% (wavelength: 600 nm).

### Example 10

### Production of photosensitive material containing black matrix

The photosensitive resin composition for forming colored pattern obtained in Example 8 was spin-coated on a glass substrate for liquid crystal display with a metal chrome light-screen film (5 cm x 5 cm), followed by drying at 80°C for 10 minutes to obtain a photosensitive material having a film thickness of 2.0 µm.

### Example 11

### Production of photosensitive material for electrodeposition method

According to the same operation as that described in Example 10 except for using a liquid crystal display glass substrate with ITO in place of the glass substrate for liquid crystal display with the metal chrome light-screen film, a photosensitive material was obtained.

### Example 12

### Production of color filter using dyeing method

A negative mask 76 mm x 76 mm (3 inch x 3 inch) in which a pixel pattern for blue color filter (90 µm x 90 µm) was formed was put on the photosensitive material obtained in Example 10, and a laminate thus obtained was exposed to ultraviolet light at a light volume of 0.2 J/cm² using an ultra-high pressure mercury lamp. After the negative mask was removed, the filter material in which a latent image was formed was dipped in the blue dyeing solution obtained in Preparation Example 4 for 2 minutes. Thereafter, it was washed with water and dried at 100°C for 10 minutes.

Then, a negative mask in which a pixel pattern for red color filter was formed was put on the position which is 20 µm away from the blue pixel in the horizontal direction, in place of the negative mask used above, and the resulting laminate was exposed to give a latent image. After the formation of the latent image, the second coloring was carried out using the red dyeing solution obtained in Preparation Example 4 according to the same operation as that described in the blue coloring. According to the same manner as that described above except for using a negative mask in which a pixel pattern for green color filter was formed and using the green dyeing solution obtained in Preparation Example 4, the third coloring was carried out to obtain a color filter. The spectral transmittance of the color filter was as follows: R: 6% (wavelength: 510 nm), G: 8% (wavelength: 450 nm), 7% (wavelength: 650 nm), B: 4% (wavelength: 600 nm).

### Example 14

### Production of color filter using electrodeposition method

A negative mask 76 mm x 76 mm (3 inch x 3 inch) in which a pixel pattern for red color filter (90 µm x 90 µm) was formed was put on the photosensitive material obtained in Example 11, and a laminate thus obtained was exposed to ultraviolet light at a light volume of 0.2 J/cm² using an ultra-high pressure mercury lamp. After the negative mask was removed, the filter material in which a latent image was formed was dipped in the electrodeposition solution for red coloring obtained in Preparation Example 5 and electrodeposited at a constant voltage of 50 V for 30 seconds. Thereafter, it was washed with water and dried at 100°C for 10 minutes.

Then, a negative mask in which a pixel pattern for blue color filter was formed was put on the position which is 20 µm away from the red pixel in the horizontal direction, in place of the negative mask used above, and the resulting laminate was exposed to give a latent image. After the formation of the latent image, the second coloring was carried out using the electrodeposition solution for blue coloring obtained in Preparation Example 5 according to the same operation as that described in red coloring. According to the same manner as that described above except for using a negative mask in which a pixel pattern for green color filter was formed and using the electrodeposition solution for green coloring obtained in Preparation Example 5, the third coloring was carried out. Finally, the laminate was exposed without using a negative mask to expose the non-exposed area of 20 µm in width, which was present between the respective color pixels. The electrodeposition was carried out using the electrodeposition solution for black coloring obtained in Preparation Example 5 to form a screen film between pixels, thereby obtaining a color filter. The spectral transmittance of the color filter was as follows: R: 7% (wavelength: 510 nm), G: 5% (wavelength: 450 nm), 4% (wavelength: 650 nm), B: 5% (wavelength: 600 nm).

### Example 15

### Production of color filter using silane coupling method

According to the same operation as that of Example 9 except for using the red, green, blue and black coloring solutions obtained in Preparation Example 6 in place of the sol for the red, green, blue and black coloring solutions obtained in Preparation Example 3, respectively, a color filter was obtained. The spectral transmittance of the resulting color filter was as follows: R: 6% (wavelength: 510 nm), G: 8% (wavelength: 450 nm), 7% (wavelength: 650 nm), B: 5% (wavelength: 600 nm).

### Example 16

### Application using air spray

According to the same operation as that of Example 9 except for applying using an air spray so that the wet film thickness may become 50 µm, in place of dipping in the sol solution for 2 minutes, a color filter was obtained. This color filter showed the same performance as that obtained in Example 9.

### Example 17

### Application using doctor blade

According to the same operation as that of Example 9 except for applying using a doctor blade so that the wet film thickness may become 50 µm, in place of dipping in the sol solution for 2 minutes, a color filter was obtained. This color filter showed the same performance as that obtained in Example 9.

### Preparation Example 7

### Preparation of silica sol to be used for method for forming functional thin film pattern

Tetraethoxysilane (13 g), ethanol (20 g) and deionized water (13 g) were charged in 200 cc beaker, and 35% concentrated hydrochloric acid (0.1 g) was added with stirring using a magnetic stirrer. After the mixture was stirred for 2 hours while maintaining the liquid temperature at. 30°C, deionized water (43 g) and acetonitrile (10 g) were charged to obtain a silica sol.

### Example 18

### Method for forming thin film pattern

The photosensitive resin composition obtained in Example 3 was applied on a glass substrate (5 cm x 5 cm x 0.11 cm in thickness) using a spin coater so that the dry film thickness may become 2 µm. A quartz photomask was put on the resulting laminate for forming thin film pattern, which was exposed to ultraviolet light at a light volume of 0.2 J/cm². After the photomask was removed, the laminate in which a latent image was formed was dipped in a sol obtained in Preparation Example 7 for 5 minutes. After dipping, the laminate was washed with water and dried at 200°C for 30 minutes to give a patterned thin film of a silica gel. Further, ultraviolet light was irradiated on the total surface of this laminate for forming thin film pattern at a light volume of 0.2 J/cm² without using a mask and the laminate was dried at 200°C for 30 minutes. As a result, a photosensitive layer other than a pattern of the silica gel was volatilized to form an irregular pattern of the thin film of the silica gel on the glass substrate. Further, the irregular pattern was completely changed into a glass of silicon oxide by calcining at 600°C for 30 minutes, and the irregular profile was measured using a surface profile measuring device (Dektak 3ST, manufactured by Ulvac Inc.). As a result, it was found that a pregroup having a height of 0.5 µm was formed. Thus, it is possible to conduct a fine irregular processing on the surface of the glass without using a stamper or etching method, according to the method for forming a thin film.

### Comparative Example 6

The same operation as that described in Example 18 was carried out using a 10 wt % toluene solution of the polysilane obtained in Preparation Example 1 in place of the photosensitive resin composition obtained in Example 3, but a sufficient irregular pattern was not obtained.

## Claims

1. A photosensitive resin composition, comprising:
(a) a polysilane having a weight-average molecular weight of not less than 10000, which is soluble in an organic solvent;
(b) a combination of a photoradical generator and an oxidizing agent;
(c) a silicone oil having a chemical structure of the formula: 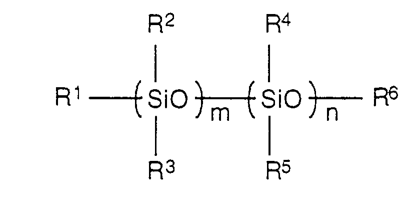 wherein R¹, R², R³, R⁴, R⁵ and R⁶ may be the same or different and indicate a group selected from the group consisting of an aliphatic hydrocarbon group having 1 to 10 carbon atoms which may be substituted with a halogen atom or a glycidyl group, an aromatic hydrocarbon group having 6 to 12 carbon atoms which may be substituted with a halogen atom, and an alkoxy group having 1 to 8 carbon atoms; and m and n are each zero or an integer, provided that m + n ≥ 1; and
(d) an organic solvent.

2. The photosensitive resin composition according to claim 1, further comprising a dye.

3. The photosensitive resin composition according to claim 1, wherein at least two of R¹ to R⁶ of the silicone oil (c) indicate an alkoxy group having 1 to 8 carbon atoms.

4. The photosensitive resin composition according to claim 1, wherein the polysilane (a) is a network type polysilane.

5. A photosensitive material obtained by applying the photosensitive resin composition of claim 1 on a substrate, followed by drying.

6. A method for forming a colored pattern, which comprises the steps of:
(A) applying the photosensitive resin composition of claim 1 on a substrate and drying the substrate to form a photosensitive layer;
(B) selectively exposing the photosensitive layer to light to form a latent image of the colored pattern; and
(C) coloring the exposed area in which the latent image of the colored pattern has been formed, using a coloring solution containing a dye or a pigment.

7. A method according to claim 6, further comprising another coloring step (D) which is carried out at least one time according to the same manner as that of the coloring step except for forming a latent image of a different coloring pattern on the above photosensitive layer and using a different dye or pigment.

8. The method according to claim 6 or 7, wherein the coloring step (C) includes a method of applying the coloring solution on the photosensitive layer.

9. The method according to claim 6 or 7, wherein the coloring step (C) includes a method of dipping the photosensitive layer in the coloring solution.

10. The method according to claim 6 or 7, wherein the coloring is carried out by electrodeposition using a transparent electrode as a transparent substrate and using an electrodepositable solution containing a dye or a pigment as the coloring solution in the coloring step (C).

11. The method according to claim 6 or 7, wherein the coloring solution is a sol of a metal oxide, which contains a dye or a pigment.

12. The method according to claim 6 or 7, wherein the coloring solution is an aqueous solution of a dye.

13. The method according to claim 6 or 7, wherein the coloring solution contains a silane coupling agent and a surfactant.

14. A color filter obtained by the method for forming a colored pattern of claim 7.

15. A method for forming a thin film pattern, which comprises the steps of:
(A') applying the photosensitive resin composition of claim 1 on a substrate and drying the substrate to form a photosensitive layer;
(B') selectively exposing the photosensitive layer to light to form a patterned latent image; and
(C') dipping the exposed area in which the patterned latent image has been formed in a sol of a metal oxide, which does not contain a pigment or a dye, or applying the sol on the exposed area.

## Patentansprüche

1. Photoempfindliche Harzzusammensetzung, umfassend
(a) ein Polysilan mit einem Gewichtsmittel des Molekulargewichts von nicht weniger als 10 000, das in einem organischen Lösungsmittel löslich ist;
(b) eine Kombination aus einem Photoradikalbildner und einem Oxidationsmittel;
(c) ein Siliconöl, das eine chemische Struktur der Formel 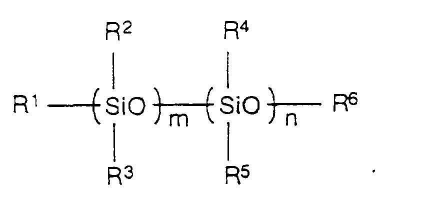 hat, worin R¹, R², R³, R⁴, R⁵ und R⁶ gleich oder unterschiedlich sein können und für eine Gruppe stehen, die ausgewählt ist aus der Gruppe bestehend aus einer aliphatischen Kohlenwasserstoff-Gruppe mit 1 bis 10 Kohlenstoffatomen, die mit einem Halogenatom oder einer Glycidyl-Gruppe substituiert sein kann, einer aromatischen Kohlenwasserstoff-Gruppe mit 6 bis 12 Kohlenstoffatomen, die mit einem Halogenatom substituiert sein kann, und einer Alkoxy-Gruppe mit 1 bis 8 Kohlenstoffatomen; und m und n jeweils O oder eine ganze Zahl sind, vorausgesetzt, daß m + n ≥ 1; und
(d) ein organisches Lösungsmittel.

2. Photoempfindliche Harzzusammensetzung nach Anspruch 1,
dadurch gekennzeichnet, daß
sie außerdem einen Farbstoff umfaßt.

3. Photoempfindliche Harzzusammensetzung nach Anspruch 1,
dadurch gekennzeichnet, daß
mindestens zwei der Gruppen R¹ bis R⁶ des Siliconöls (c) für eine Alkoxy-Gruppe mit 1 bis 8 Kohlenstoffatomen stehen.

4. Photoempfindliche Harzzusammensetzung nach Anspruch 1,
dadurch gekennzeichnet, daß
das Polysilan (a) ein Polysilan des Vernetzungstyps ist.

5. Photoempfindliches Material, das durch Auftragen der photoempfindlichen Harzzusammensetzung nach Anspruch 1 auf ein Substrat, gefolgt von einem Trocknen, erhalten wird.

6. Verfahren zur Bildung eines farbigen Musters, das die folgenden Schritte umfaßt:
(A) Auftragen der photoempfindlichen Harzzusammensetzung nach Anspruch 1 auf ein Substrat unter Bildung einer photoempfindlichen Schicht;
(B) selektives Belichten der photoempfindlichen Schicht unter Erzeugung eines latenten Bildes des farbigen Musters und
(C) Färben des belichteten Bereichs, in dem das latente Bild des farbigen Musters gebildet wurde, unter Verwendung einer färbenden Lösung, die einen Farbstoff oder ein Pigment enthält.

7. Verfahren nach Anspruch 6,
dadurch gekennzeichnet, daß
es außerdem einen weiteren Färbeschritt (D) umfaßt, der mindestens einmal in der gleichen Weise wie der Färbeschritt, außer daß ein latentes Bild eines anderen färbenden Musters auf der photoempfindlichen Schicht erzeugt wird und ein anderer Farbstoff oder ein anderes Pigment verwendet wird, durchgeführt wird.

8. Verfahren nach Anspruch 6 oder 7,
dadurch gekennzeichnet, daß
der Färbeschritt (C) ein Verfahren eines Auftragens der färbenden Lösung auf die photoempfindliche Schicht beinhaltet.

9. Verfahren nach Anspruch 6 oder 7,
dadurch gekennzeichnet, daß
der Färbeschritt (C) ein Verfahren eines Eintauchens der photoempfindlichen Schicht in die färbende Lösung beinhaltet.

10. Verfahren nach Anspruch 6 oder Anspruch 7,
dadurch gekennzeichnet, daß
das Färben durch elektrochemische Abscheidung unter Verwendung einer transparenten Elektrode als transparentes Substrat und unter Verwendung einer elektrochemisch abscheidbaren Lösung, die einen Farbstoff oder ein Pigment enthält, als färbende Lösung im Färbeschritt (C) durchgeführt wird.

11. Verfahren nach Anspruch 6 oder 7,
dadurch gekennzeichnet, daß
die färbende Lösung ein Sol eines Metalloxids ist, das einen Farbstoff oder ein Pigment enthält.

12. Verfahren nach Anspruch 6 oder Anspruch 7,
dadurch gekennzeichnet, daß
die färbende Lösung eine wäßrige Lösung eines Farbstoffs ist.

13. Verfahren nach Anspruch 6 oder Anspruch 7,
dadurch gekennzeichnet, daß
färbende Lösung ein Silan-Haftmittel und ein oberflächenaktives Mittel enthält.

14. Farbfilter, das nach dem Verfahren zur Bildung eines farbigen Musters nach Anspruch 7 erhalten wird.

15. Verfahren zur Bildung eines Dünnschichtmusters, das die folgenden Schritte umfaßt:
(A') Auftragen der photoempfindlichen Harzzusammensetzung nach Anspruch 1 auf ein Substrat und Trocknen des Substrats unter Bildung einer photoempfindlichen Schicht;
(B') selektives Belichten der photoempfindlichen Schicht unter Erzeugung eines gemusterten latenten Bildes und
(C') Eintauchen des belichteten Bereichs, in dem das gemusterte latente Bild erzeugt wurde, in ein Sol eines Metalloxids, das kein Pigment oder keinen Farbstoff enthält, oder Auftragen des Sols auf den belichteten Bereich.

## Revendications

1. Composition de résine photosensible, comprenant :
(a) un polysilane ayant un poids moléculaire moyen en poids inférieur à 10 000 qui est soluble dans un solvant organique ;
(b) une combinaison d'un générateur photoradicalaire et d'un agent oxydant ;
(c) une huile de silicone ayant une structure chimique de formule : 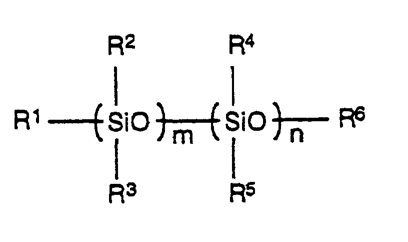 dans laquelle R¹, R², R³, R⁴, R⁵ et R⁶, qui peuvent être identiques ou différents, représentent un groupe choisi dans le groupe constitué par un groupe aliphatique hydrocarboné ayant de 1 à 10 atomes de carbone qui peut être substitué par un atome d'halogène ou un groupe glycidyle, un groupe aromatique hydrocarboné ayant de 6 à 12 atomes de carbone qui peut être substitué par un atome d'halogène, et un groupe alkoxy ayant 1 à 8 atomes de carbone ; et m et n sont chacun zéro ou un nombre entier, sous réserve que m + n ≥ 1 ; et
(d) un solvant organique.

2. Composition de résine photosensible selon la revendication 1 comprenant en outre un colorant.

3. Composition de résine photosensible selon la revendication 1 dans laquelle au moins deux des R¹ à R⁶ de l'huile de silicone (c) représentent un groupe alkoxy ayant de 1 à 8 atomes de carbone.

4. Composition de résine photosensible selon la revendication 1 dans laquelle le polysilane est un polysilane du type réticulé.

5. Matériau photosensible obtenu par application de la composition de résine photosensible selon la revendication 1 sur un substrat suivi par un séchage.

6. Procédé pour former un motif coloré qui comprend les étapes :
(A) d'application de la composition de résine photosensible de la revendication 1 sur un substrat et le séchage du substrat pour former une couche photosensible ;
(B) d'exposition sélective de la couche photosensible à la lumière pour former une image latente du motif coloré ; et
(C) de coloration de la zone exposée sur laquelle l'image latente du motif coloré a été formée, en utilisant une solution colorante contenant un colorant ou un pigment.

7. Procédé selon la revendication 6, qui comprend en outre une autre étape de coloration (D), qui est réalisée au moins une fois selon la même méthode que celle de l'étape de coloration à l'exception de la formation d'une image latente d'un motif de coloration différent sur la couche photosensible et l'utilisation d'un colorant ou pigment différent.

8. Procédé selon la revendication 6 ou 7 dans lequel l'étape de coloration (C) comprend une méthode d'application de la solution de coloration sur la couche photosensible.

9. Procédé selon la revendication 6 ou 7 dans lequel l'étape de coloration (C) comprend une méthode d'immersion de la couche photosensible dans la solution colorante.

10. Procédé selon la revendication 6 ou 7 dans lequel la coloration est réalisée par électrodéposition en utilisant une électrode transparente comme substrat transparent et en utilisant une solution électrodéposable contenant un colorant ou un pigment en tant que solution colorante dans l'étape de coloration (C).

11. Procédé selon la revendication 6 ou 7 dans lequel la solution colorante est un sol d'oxyde métallique qui contient un colorant ou un pigment.

12. Procédé selon la revendication 6 ou 7 dans lequel la solution colorante est une solution aqueuse d'un colorant.

13. Procédé selon la revendication 6 ou 7 dans lequel la solution colorante contient un agent de couplage silane et un tensio-actif.

14. Filtre couleur obtenu par le procédé de formation d'un motif coloré selon la revendication 7.

15. Procédé pour former un motif en un film mince qui comprend les étapes :
(A') d'application de la composition de résine photosensible de la revendication 1 sur un substrat et séchage du substrat pour former une couche photosensible ;
(B') d'exposition sélective de la couche photosensible à la lumière pour former une image latente à motifs ; et
(C') d'immersion de la zone exposée sur laquelle l'image latente à motifs a été formée dans un sol d'un oxyde métallique, qui ne contient pas un pigment ou un colorant ou l'application du sol sur la zone exposée.
